# EUROPEAN PATENT APPLICATION

(11) **EP 4 703 794 A1**
(43) Date of publication of application: **04.03.2026**
(21) Application number: 24796898.5
(22) Date of filing: 17.04.2024
(51) Int. Cl.: G03F 7/004, B41C 1/055, B41N 1/12, G03F 7/00, G03F 7/027, G03F 7/095

(54) **FLEXOGRAPHIC PRINTING ORIGINAL PLATE, AND METHOD FOR MANUFACTURING FLEXOGRAPHIC PRINTING PLATE**

(30) Priority: 25.04.2023 JP 2023071540
(71) Applicant: Asahi Kasei Kabushiki Kaisha, Tokyo 1000006 (JP)
(72) Inventor: YAMAGUCHI, Misuzu, Tokyo 100-0006 (JP); AKIYAMA, Hiroki, Tokyo 100-0006 (JP)
(74) Representative: Strehl & Partner mbB
(86) International application number: PCT/JP2024/015333
(87) International publication number: WO 2024/225145

(57) **Abstract**

An original flexographic printing plate containing at least: a support (a); a photosensitive resin composition layer (b) laminated thereon; and an infrared ray ablation layer (c) laminated thereon, wherein
when a photo-differential scanning calorimetry is carried out under normal temperature and normal pressure while irradiating a molded product of 0.5 mm thickness formed of a photosensitive resin composition constituting the photosensitive resin composition layer (b) with a light of 365 nm wavelength at an illuminance of 10 mW/cm², a time from start of irradiation to a heat generation peak is 4.0 seconds or more and 8.5 seconds or less, and an amount of heat generation at a peak top is 1500 µW/mg or more and 3000 µW/mg or less.

## Description

### Technical Field

The present invention relates to an original flexographic printing plate, and a method for producing a flexographic printing plate.

### Background Art

Flexographic printing is a printing method in which ink is transferred from a flexographic printing plate to a body to be printed by placing ink on a protrusion of the flexographic printing plate and pressing the flexographic printing plate against the body to be printed.

The flexographic printing plate used for flexographic printing is generally made using an original flexographic printing plate of a structure having a polyester film as a support and a photosensitive resin composition layer laminated thereon.

Examples of the method for producing the flexographic printing plate from the original flexographic printing plate include the following methods.

First, ultraviolet exposure (back exposure) is performed on the entire surface of the photosensitive resin composition layer through a polyester film as a support to provide a thin uniform cured layer. Then, a negative film is placed on the photosensitive resin composition layer, and image exposure (relief exposure) is performed on the photosensitive resin composition layer through the negative film, and the photosensitive resin composition layer is photocured according to the pattern of the negative film. The unexposed portion (i.e., the uncured portion) in the photosensitive resin composition layer is then washed with a developing solution to form a desired image, i.e., a relief image, to obtain a flexographic printing plate.

In recent years, instead of the method using a negative film described above, a technique in which an ablation layer that can be removed with an infrared laser is provided on a photosensitive resin composition layer, and the ablation layer is cut into a desired pattern with a laser, and then a part that is cured with ultraviolet ray by performing exposure and a part that is not cured with ultraviolet ray are provided, commonly known as digital plate-making technique, has become widespread.

The digital plate-making technique saves time and effort in making a negative film compared to the conventional analog plate-making technique using a negative film, and further has the advantage that higher-resolution images can be made.

However, one of the challenges of the digital plate-making technique is an issue of defective formation of flexographic printing plate due to so-called oxygen inhibition, which inhibits curing reaction of the photosensitive resin by oxygen. In particular, in tiny dot portions called highlights, the edge of the relief forms a rounded shape dot due to oxygen inhibition, that is, a round top dot, so the boundary between the printing portion and the non-printing portion becomes blurred, and the printing quality may be significantly degraded due to slight differences in printing conditions. In addition, the round top dot has a problem in that it is difficult to keep the dot image bright before and after printing because the dots wear out and the dot size tends to become large as the number of print runs increases.

In recent years, in view of the demands for higher definition, and brighter and higher resolution printing quality for flexographic printing, a digital plate-making technique that forms flat top dots, that is, dots with a flat top shape, where the boundary between the printing portion and the non-printing portion is clear and the dot size remains stable throughout printing is required.

In view of the above-mentioned problems, there have been conventionally known techniques to improve the curing reaction speed of the surface of the flexographic printing plate rather than the curing failure due to the impact of oxygen inhibition, using a high-illuminance exposure machine with LEDs or the like. With the development of high-illuminance exposure machines, such techniques will become increasingly mainstream in the future, and high-illuminance exposure machines are expected to gain wider adoption.

However, because of the high cost of installing equipment of a high-illuminance exposure machine, it is often necessary to use a low-illuminance exposure machine with a conventional high-pressure mercury lamp or the like. To form a flat top dot with a low-illuminance exposure machine, for example, Patent Literature 1 proposes a technique to prepare a flexographic printing plate with reduced impact from oxygen inhibition by placing an oxygen barrier film between a laser ablation layer and a photosensitive resin composition layer.

In addition, Patent Literature 2 proposes a technique to prepare a flexographic printing plate with improved sensitivity of a photosensitive resin composition layer.

### Citation List

### Patent Literature

Patent Literature 1: Japanese Translation of PCT International Application Publication No. 10-509254
Patent Literature 2: Japanese Translation of PCT International Application Publication No. 2015-529345

### Summary of Invention

### Technical Problem

However, the flexographic printing plates prepared by the techniques disclosed in Patent Literatures 1 and 2 have disadvantages that, while flat top dots of an appropriate size and shape are formed when the plate is made with a low-illuminance exposure machine, but when the plate is made with a high-illuminance exposure machine, halftone dots are formed excessively, the dot size becomes large, and the image becomes darker during printing. Thus, in the digital plate-making technique, it is necessary to use different flexographic printing plates depending on the illuminance of the exposure machine, which causes a problem of complicated operation.

Currently, various exposure machines of different illuminances are present in the market, but from the viewpoint of grade integration, it is important to develop a technique for producing a flexographic printing plate that can form a flat top dot of an appropriate size even with an exposure machine of any illuminance.

Accordingly, an object of the present invention is to provide an original flexographic printing plate in which the dot formability when the plate is made under low-illuminance exposure is excellent and the excessive halftone dot formation when the plate is made under high-illuminance exposure is suppressed.

### Solution to Problem

The present inventors have conducted diligent studies to solve the problems above and have found that the above-described problems can be solved by specifying the time from irradiation to the heat generation peak and the amount of heat generation at the peak top when the photosensitive resin composition layer is measured by a photo-differential scanning calorimetry (photo-DSC) to a predetermined numerical range, and thereby completed the present invention.

That is, the present invention is as follows.
[1] An original flexographic printing plate comprising: at least a support (a); a photosensitive resin composition layer (b) laminated thereon; and an infrared ray ablation layer (c) laminated thereon, wherein
   when a photo-differential scanning calorimetry is carried out under normal temperature and normal pressure while irradiating a molded product of 0.5 mm thickness formed of a photosensitive resin composition constituting the photosensitive resin composition layer (b) with a light of 365 nm wavelength at an illuminance of 10 mW/cm², a time from start of irradiation to a heat generation peak is 4.0 seconds or more and 8.5 seconds or less, and an amount of heat generation at a peak top is 1500 µW/mg or more and 3000 µW/mg or less.
[2] The original flexographic printing plate according to [1], wherein
   the photosensitive resin composition layer (b) contains at least one or more selected from the group consisting of an ethylenically unsaturated compound (b-2), a photopolymerization initiator (b-3), a stabilizer (b-5), and a dye (b-6).
[3] The original flexographic printing plate according to [2], wherein
   the dye (b-6) contains a dye (B-6) having a 1,4-diamino-5,8-dihydroxyanthraquinone backbone in a molecular structure.
[4] The original flexographic printing plate according to [3], wherein
   the dye (B-6) has a molecular structure represented by the following formula (1): 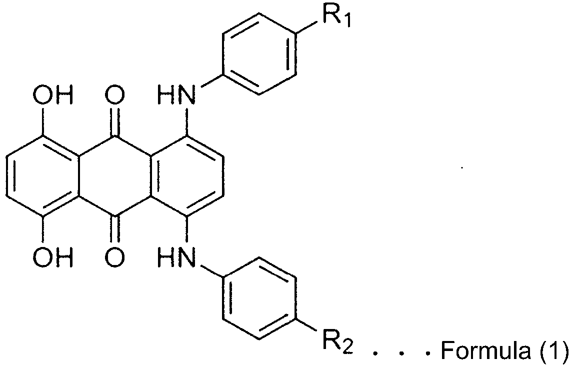 wherein R₁ and R₂ each independently represent an alkyl group having 1 to 4 carbon atoms.
[5] The original flexographic printing plate according to [4], wherein
   a dye having a molecular structure represented by the formula (1) is contained in the photosensitive resin composition layer (b) in an amount of 0.005% by mass or more and 0.1% by mass or less.
[6] The original flexographic printing plate according to any one of [2] to [5], wherein
   at least one stabilizer (B-5), which is a compound represented by the following formula (2) or (3), is contained as the stabilizer (b-5); and
   a content of the stabilizer (B-5) is 0.45% by mass or less of the photosensitive resin composition layer (b): 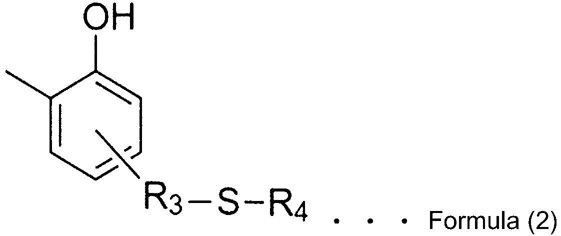 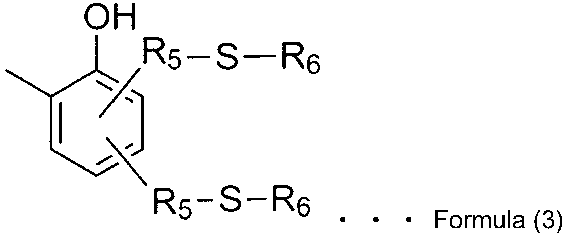 wherein, R₃ and R₅ each independently represent an alkyl group having 1 to 4 carbon atoms; and R₄ and R₆ each independently represent an alkyl group having 1 to 12 carbon atoms.
[7] The original flexographic printing plate according to [6], wherein
   the content of the stabilizer (B-5) is 60% by mass or more and 100% by mass or less based on the total amount of the stabilizer (b-5).
[8] The original flexographic printing plate according to any one of [2] to [5], wherein
   an ethylenically unsaturated compound (B-2) having a structure represented by the following formula (4) is contained as the ethylenically unsaturated compound (b-2): 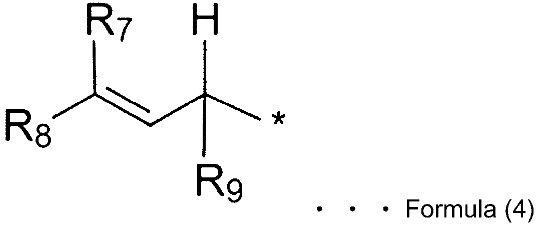 wherein, R₇, R₈, and R₉ each independently represent a hydrogen atom or a hydrocarbon group having 1 to 3 carbon atoms; and * represents a bond.
[9] The original flexographic printing plate according to [8], wherein
   a compound represented by the following formula (5) is contained as the ethylenically unsaturated compound (B-2): 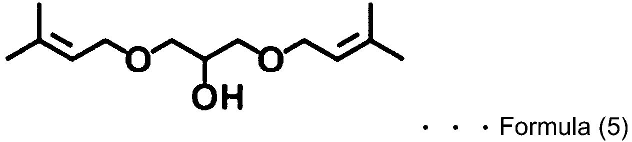
[10] A method for producing a flexographic printing plate using the original flexographic printing plate according to any one of [1] to [8] comprising:
   a first step of performing ultraviolet ray irradiation from a side of the support (a);
   a second step of laser-ablating an infrared ray ablation layer (c) provided on the photosensitive resin composition layer (b) to form a negative pattern;
   a third step of irradiating the photosensitive resin composition layer (b) with an ultraviolet ray for pattern exposure using, as a mask, the infrared ray ablation layer (c) on which the pattern is drawn and processed; and
   a fourth step of removing an unexposed portion of the photosensitive resin composition layer (b).
[11] The method for producing a flexographic printing plate according to [10], wherein
   solvent development is performed in the fourth step of removing the unexposed portion of the photosensitive resin composition layer (b).
[12] The method for producing a flexographic printing plate according to [10], wherein
   heat development is performed in the fourth step of removing the unexposed portion of the photosensitive resin composition layer (b).

### Advantageous Effect of Invention

According to the present invention, it is possible to provide an original flexographic printing plate with which a flexographic printing plate that can form a flat top dot even in highlight dots at the time of low-illuminance exposure and can suppress excessive halftone dot formation at the time of high-illuminance exposure can be obtained.

### Brief Description of Drawings

[Figure 1] Figure 1 is a schematic cross-section view of an original flexographic printing plate according to the present embodiment.
[Figure 2] Figure 2 is a schematic diagram illustrating a method for producing a flexographic printing plate using the original flexographic printing plate according to the present embodiment.
[Figure 3] Figure 3 is a diagram showing a heat generation behavior when an photo-DSC of the photosensitive resin composition layer (b) in the original flexographic printing plate of Example 4 is measured.

### Description of Embodiments

Hereinafter, embodiments for carrying out the present invention (hereinafter, referred to as "present embodiment") will be described in detail.

It should be noted that the following present embodiments are examples for describing the present invention, and are not intended to limit the present invention to the following contents. The present invention can be practiced in various variations without departing from the scope thereof.

### [Original Flexographic Printing Plate]

The original flexographic printing plate of the present embodiment includes at least a support (a); a photosensitive resin composition layer (b) laminated thereon; and an infrared ray ablation layer (c) laminated thereon.

When a photo-differential scanning calorimetry (hereinafter referred to as measurement by photo-DSC) is carried out under air, that is, under normal temperature (about 25°C) and normal pressure while irradiating a molded product of 0.5 mm thickness formed of a photosensitive resin composition constituting the photosensitive resin composition layer (b) with a light of 365 nm wavelength at an illuminance of 10 mW/cm², the time from the start of irradiation to the heat generation peak is 4.0 seconds or more and 8.5 seconds or less, and the amount of heat generation at the peak top is 1500 µW/mg or more and 3000 µW/mg or less.

By having the above configuration, it is possible to provide an original flexographic printing plate that a flexographic printing plate which can form a flat top dot at the time of low-illuminance exposure even in highlight dot portions and that can suppress excessive halftone dot formation at the time of high-illuminance exposure can be obtained.

As used herein, the low-illuminance exposure means exposure with a light of 365 nm at an illuminance of 15 mW/cm² or less, and the high-illuminance exposure means exposure with a light of 365 nm at an illuminance of 50 mW/cm² or more. There is no limitation to exposure machines used in each exposure condition.

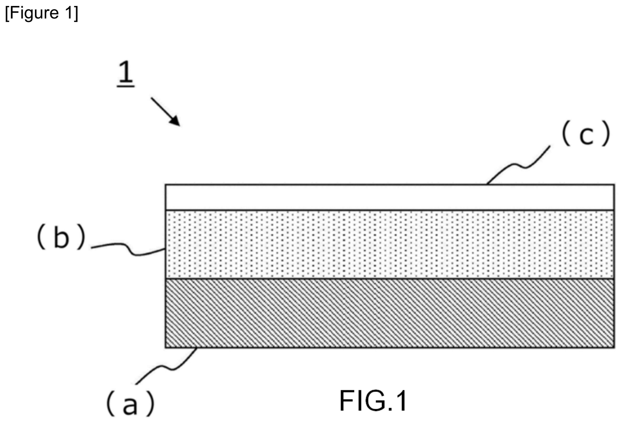

Figure 1 is a schematic cross-section view of the original flexographic printing plate 1 of the present embodiment.

The original flexographic printing plate of the present embodiment comprises a support (a) and a photosensitive resin composition layer (b) on which a convexo-concave pattern of a flexographic printing plate is formed.

In addition, the original flexographic printing plate 1 of the present embodiment may have a thin protective layer with solvent solubility and flexibility, which has the function of improving the contactability with a predetermined negative film (see, for example, Japanese Patent Publication No. 5-13305), as necessary.

In the original flexographic printing plate 1 of the present embodiment shown in Figure 1, an infrared ray ablation layer (c) that functions as a mask when the convexo-concave pattern is formed is laminated on a photosensitive resin composition layer (b).

In the original flexographic printing plate of the present embodiment, other layers may be provided between each layer as needed.

Hereinafter, the original flexographic printing plate of the present embodiment will be described.

### (Support (a))

Examples of the support (a) for use in the original flexographic printing plate of the present embodiment include, but are not particularly limited to, a polyester film, a polyamide film, a polyacrylonitrile film, and a polyvinyl chloride film.

The support (a) is preferably a polyester film.

Examples of the polyester used for the support (a) include, but are not limited to, polyethylene terephthalate, polybutylene terephthalate, and polyethylene naphthalate.

The thickness of the support (a) is not particularly limited, but is preferably 50 µm or more and 300 µm or less.

An adhesive layer may be provided on the support (a) in order to enhance the adhesive force between the support (a) and the photosensitive resin composition layer (b) which will be described later. Examples of the adhesive layer include, but are not limited to, the adhesive layer described in International Publication No. WO 2004/104701.

### (Photosensitive Resin Composition Layer (b))

As a result of intensive study, the present inventors have focused on the heat generation behavior of photo-DSC in the photosensitive resin composition layer (b) constituting the original flexographic printing plate from the viewpoint of compatibility of the formability of highlight dot portion at the time of low-illuminance exposure and the suppression of excessive halftone dot formation at the time of high-illuminance exposure, and have found that it is particularly important to control the time from the start of irradiation to the heat generation peak and the amount of heat generation at the peak top to a certain range.

The photo-DSC (Differential Scanning Calorimeter) is a device that performs photo-differential scanning calorimetry, in particular, a device that analyzes photocuring behavior by irradiating an ultraviolet curable photosensitive resin with ultraviolet rays and measuring the heat of reaction.

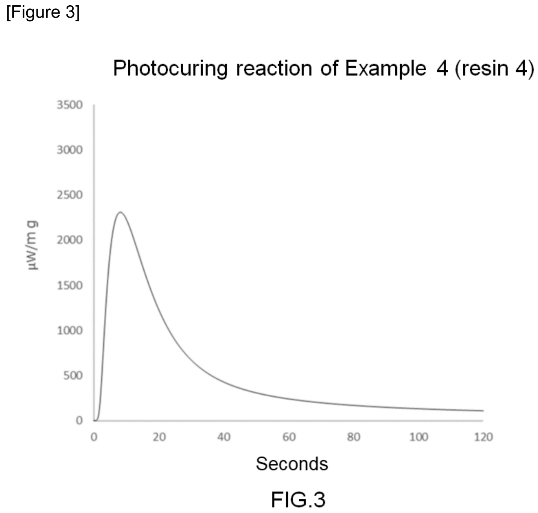

Figure 3 shows a graph of the measurement results of photo-DSC when irradiated the sample of Example 4 described later with a light of 365 nm at an illuminance of 10 mW/cm².

In Figure 3, the horizontal axis represents time (seconds), and the vertical axis represents the amount of heat generation (µW/mg).

In the horizontal axis, the start of irradiation is set to 0 seconds.

The heat generation peak refers to the maximum value of the curve shown in Figure 3, and the time to the heat generation peak refers to the time from the start of irradiation to reach the peak.

As a result of intensive study by the present inventors, it has been found that by specifying the reaction time of photo-DSC and the reaction heat at the reaction peak to a certain range, the defective dot formation at the time of low-illuminance exposure and the excessive dot formation at the time of high-illuminance exposure can be controlled, respectively. In particular, the present inventors have focused on the reaction process as described later, rather than the total amount of reaction heat, at the time of high-illuminance exposure and have found that it is important to control the instantaneous amount of heat generation at the heat generation peak where the photocuring reaction is most advanced.

Specifically, when the original flexographic printing plate is exposed with low-illuminance, the radicals generated from a photo-initiator in the surface of the photosensitive resin composition layer are consumed by oxygen in the atmosphere, thereby slowing the rate of curing reaction and reducing the formability of the flexographic printing plate. Thus, in the low-illuminance exposure conditions, how to minimize the impact of oxygen inhibition is the point of improving the formability of flexographic printing plate. Reducing the time from the start of the photocuring reaction to the peak of the reaction is to improve the reaction speed at the initial stage of the reaction, that is, at the starting stage of the photocuring reaction. Thus, when the time from the start of light irradiation to the heat generation peak is shortened, the reaction start speed is increased, and the impact of oxygen inhibition is suppressed, thereby improving the formability of the flexographic printing plate under low-illuminance exposure conditions.

On the other hand, when the original flexographic printing plate is exposed with high-illuminance, radicals are rapidly generated from the photo-reaction initiator, and the photocuring reaction progresses instantaneously, so that halftone dots tend to be formed excessively. Thus, to suppress the excessive halftone dot formation, it is important to control the radical amount at the time when the photocuring reaction is most advanced. In other words, suppressing the amount of heat generation at the heat generation peak of photo-DSC to a certain threshold is important for controlling the formability of the flexographic printing plate and suppressing excessive halftone dot formation at the time of exposure using a high-illuminance exposure machine.

To exert such an effect on the excellent formability of the flexographic printing plate as described above, it is necessary that, when a measurement by photo-DSC is carried out under air, that is, under normal temperature (about 25°C) and normal pressure while irradiating a molded product of 0.5 mm thickness formed of a photosensitive resin composition constituting the photosensitive resin composition layer (b) of the original flexographic printing plate with a light of 365 nm wavelength at an illuminance of 10 mW/cm², the time from the start of irradiation to the heat generation peak is 4.0 seconds or more and 8.5 seconds or less, and the amount of heat generation at the peak top is 1500 to 3000 µW/mg.

In the above numerical range, there is a tendency to exhibit excellent flat top dot formability both at the time of low-illuminance exposure and at the time of high-illuminance exposure.

When the time to the heat generation peak is 8.5 seconds or less, excellent highlight dot formability can be obtained in the original flexographic printing plate even at the time of low-illuminance exposure.

In addition, when the amount of heat generation at the peak top is 3000 µW/mg or less, excellent suppression effect on excessive halftone dot formation can be obtained at the time of high-illuminance exposure.

From the viewpoint of compatibility of excellent highlight dot formability at the time of low-illuminance exposure and suppression of excessive halftone dot formation at the time of high-illuminance exposure, the time to the heat generation peak is 4.0 seconds or more and 8.5 seconds or less, preferably 5 seconds or more and 8.5 seconds or less, more preferably 7.1 seconds or more and 8.5 seconds or less, and further preferably 7.1 seconds or more and 8.3 seconds or less.

From the same viewpoint, the amount of heat generation at the peak top is 1500 µW/mg or more and 3000 µW/mg or less, preferably 1800 µW/mg or more and 3000 µW/mg or less, more preferably 1900 µW/mg or more and 2900 µW/mg or less, and further preferably 2000 µW/mg or more and 2800 µW/mg or less.

The time from the start of irradiation to the heat generation peak and the amount of heat generation at the peak top in the photo-differential scanning calorimetry can be controlled to the above numerical range by adjusting the constituent material of the photosensitive resin composition layer (b).

Specifically, it is effective to use an ethylenically unsaturated compound (b-2), a photopolymerization initiator (b-3), a stabilizer (b-5), and a dye (b-6), which will be described later as constituent materials of the photosensitive resin composition layer (b), and to adjust the composition thereof.

For example, the more the photopolymerization initiator (b-3) and the ethylenically unsaturated compound (b-2) are contained, the faster the heat is generated, the shorter the time until the heat generation peak is, and the amount of heat generation at the peak top tends to increase. This is believed to be because the reaction speed of the photo-polymerization initiator (b-3) and the ethylenically unsaturated compound (b-2) is increased, thereby suppressing the impact of oxygen inhibition and increasing the reaction heat. On the other hand, the more stabilizer (b-5) and dye (b-6) are contained, the time to the heat generation peak is longer, and the amount of heat generation at the peak top tends to decrease. It is believed that the dye absorbs ultraviolet rays and the stabilizer suppresses the excessive reaction, thereby suppressing the reaction speed of the radical reaction and slowing the heat generation time and amount of heat generation. Thus, to control the time to the heat generation peak and the amount of heat generation at the peak top, it is effective to adjust the amounts of the ethylenically unsaturated compound (b-2), the photopolymerization initiator (b-3), the stabilizer (b-5), and the dye (b-6), and the relative proportion of each component.

The original flexographic printing plate of the present embodiment has the photosensitive resin composition layer (b) on the support (a).

The photosensitive resin composition layer (b) may be laminated directly on the support (a) or may be indirectly laminated via a predetermined adhesive layer.

Preferred examples of the materials of the photosensitive resin composition layer (b) can include a photosensitive resin composition comprising a thermoplastic elastomer (b-1), an ethylenically unsaturated compound (b-2), a photopolymerization initiator (b-3), a stabilizer (b-5), a dye (b-6), and a liquid diene (b-4). The photosensitive resin composition layer (b) includes at least one or more selected from the group consisting of these, and these can be used selectively as appropriate.

The photosensitive resin composition layer (b) may further contain an auxiliary additive component, if necessary.

Hereinafter, each component is described in detail.

### <Thermoplastic Elastomer (b-1)>

Examples of the thermoplastic elastomer (b-1) include, but are not limited to, a copolymer having a constituent unit derived from a monovinyl-substituted aromatic hydrocarbon and a constituent unit derived from a conjugated diene. The thermoplastic elastomer (b-1) may further have a constituent unit derived from other monomers. The use of such a thermoplastic elastomer tends to further improve the printing durability of a flexographic printing plate produced using the original flexographic printing plate according to the present embodiment.

The thermoplastic elastomer (b-1) may be a random copolymer or a block copolymer, but is preferably a block copolymer having a polymer block formed from a monovinyl-substituted aromatic hydrocarbon and a polymer block formed from a conjugated diene.

The use of such a thermoplastic elastomer tends to further improve a printing durability of the flexographic printing plate produced using the original flexographic printing plate according to the present embodiment.

Examples of the monovinyl-substituted aromatic hydrocarbon that constitutes the thermoplastic elastomer (b-1) include, but are not limited to, styrene, t-butylstyrene, 1,1-diphenylethylene, N,N-dimethyl-p-aminoethylstyrene, N,N-diethyl-p-aminoethylstyrene, vinylpyridine, p-methylstyrene, p-methoxystyrene, tertiary-butylstyrene, α-methylstyrene, and 1,1-diphenylethylene. These may be used singly or in combinations of two or more thereof.

Among these, the monovinyl-substituted aromatic hydrocarbon is preferably styrene, from the viewpoint of enabling the photosensitive resin composition layer (b) to be molded smoothly at a relatively low temperature.

Examples of the conjugated diene that constitutes the thermoplastic elastomer (b-1) include, but are not limited to, 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene.

These may be used singly or in combinations of two or more thereof.

Among these, the conjugated diene is preferably 1,3-butadiene from the viewpoint of printing durability of the flexographic printing plate produced using the original flexographic printing plate of the present embodiment.

The thermoplastic elastomer (b-1) preferably has a number average molecular weight (Mn) of 20,000 or more and 300,000 or less, and more preferably 50,000 or more and 200,000 or less from the viewpoint of viscosity at normal temperature. The number average molecular weight can be measured by gel permeation chromatography (GPC) and is expressed by a molecular weight in terms of polystyrene.

When the thermoplastic elastomer (b-1) is a block copolymer having a polymer block formed from a monovinyl-substituted aromatic hydrocarbon and a polymer block formed from a conjugated diene, examples of the thermoplastic elastomer (b-1) include linear block copolymers represented by the following formula group (I) and/or linear block copolymers or radial block copolymers represented by the following formula group (II).

Formula group (I): (A-B)ₙ, A-(B-A)ₙ, A-(B-A)ₙ-B, B-(A-B)ₙ

Formula group (II): [(A-B)ₖ]ₘ-X, [(A-B)ₖ-A]ₘ-X, [(B-A)ₖ]ₘ-X, [(B-A)ₖ-B]ₘ-X

In the formula group (I) and the formula group (II), A represents a polymeric block consisting of a monovinyl-substituted aromatic hydrocarbon. B represents a polymeric block consisting of a conjugated diene. X represents a residual group of a coupling agent selected from the group consisting of silicon tetrachloride, tin tetrachloride, epoxidized soybean oil, a poly(halogenated hydrocarbon) compound, a carboxylic acid ester compound, a polyvinyl compound, a bisphenol-type epoxy compound, an alkoxysilane compound, a halogenated silane compound, an ester-based compound, and the like, or a residual group of a polymerization initiator such as a multifunctional organolithium compound.

In the formula group (I) and the formula group (II), n, k, and m each represent an integer of at least one, for example, 1 to 5.

The content of the conjugated diene and of the monovinyl-substituted aromatic hydrocarbon in the thermoplastic elastomer (b-1) can be measured using a nuclear magnetic resonance apparatus (¹H-NMR). Specifically, the contents can be measured by using JNM-LA400 (manufactured by JEOL Ltd., trade name) as a¹H-NMR measurement device, using deuterated chloroform as a solvent, setting the sample concentration to 50 mg/mL, setting a measurement frequency at 400 MHz, using tetramethylsilane (TMS) as a standard of chemical shifts, and setting a pulse delay to 2.904 seconds, the number of times of scanning to 64, a pulse width to 45°, and a measurement temperature to 25°C.

When the ratio of monovinyl-substituted aromatic hydrocarbons is reduced in the thermoplastic elastomer (b-1), the hardness of the flexographic printing plate produced using the original flexographic printing plate of the present embodiment is lowered, and thus the softness of the flexographic printing plate is improved. When the ratio of monovinyl-substituted aromatic hydrocarbon increases, the hardness of the flexographic printing plate is raised, and thus printing durability of the flexographic printing plate is improved. From the viewpoint of compatibility of softness and printing durability of the flexographic printing plate, the copolymerization ratio (mass ratio) between the monovinyl-substituted aromatic hydrocarbon and the conjugated diene is preferably in the range of monovinyl-substituted aromatic hydrocarbon/conjugated diene = 10/90 to 60/40, more preferably in the range of 15/85 to 50/50, and further preferably in the range of 15/85 to 40/60.

In the thermoplastic elastomer (b-1), when the ratio of double bonds in the side chain of the double bonds contained in the polymer block consisting of a conjugated diene is reduced, the loss modulus G" at -30°C and 2.5 Hz in the cured product obtained by molding a photosensitive resin composition constituting the photosensitive resin composition layer (b) of the original flexographic printing plate of the present embodiment to a thickness of 1.5 mm and curing with an ultraviolet ray is reduced. Thus, from the viewpoint of controlling the dynamic viscoelasticity of the photosensitive resin composition constituting the photosensitive resin composition layer (b) of the original flexographic printing plate, the molar ratio of the amount of double bonds in the side chain of all the double bonds contained in the polymer block consisting of the conjugated diene in the structure of the thermoplastic elastomer (b-1) is preferably 3 mol% or more and 30 mol% or less, more preferably 3 mol% or more and 25 mol% or less.

The ratio of the amount of the double bond contained in the main chain to the amount of double bond contained in the side chain in the polymer block consisting of the conjugated diene in the thermoplastic elastomer (b-1) can be calculated using the nuclear magnetic resonance apparatus (¹H-NMR) described above.

By increasing the content of thermoplastic elastomer (b-1) in the photosensitive resin composition layer (b), the printing durability of the flexographic printing plate produced using the original flexographic printing plate of the present embodiment tends to be improved. When the content of the thermoplastic elastomer (b-1) in the photosensitive resin composition (b) decreases, the hardness of the flexographic printing plate is lowered, and the softness of the flexographic printing plate is improved. From the viewpoint of compatibility of printing durability and softness of the flexographic printing plate, when the total amount of the photosensitive resin composition layer (b) is 100.0% by mass, the content of the thermoplastic elastomer (b-1) in the photosensitive resin composition layer (b) is preferably 40.0% by mass or more and 80.0% by mass or less, and more preferably 50.0% by mass or more and 75.0% by mass or less.

### <Ethylenically unsaturated compound (b-2)>

The photosensitive resin composition layer (b) preferably contains an ethylenically unsaturated compound (b-2), as described above. The ethylenically unsaturated compound (b-2) is a compound having a radically polymerizable unsaturated double bond.

The photosensitive resin composition for the original flexographic printing plate of the present embodiment preferably contains an ethylenically unsaturated compound having a structure represented by the following formula (4) (hereinafter, it may be referred to as ethylenically unsaturated compound (B-2)) as the ethylenically unsaturated compound (b-2).

The ethylenically unsaturated compound (B-2) may be part or all of the ethylenically unsaturated compound (b-2): 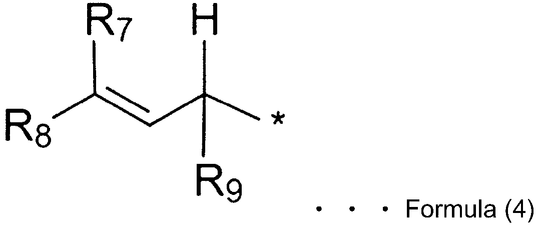 wherein, R₇, R₈, and R₉ each independently represent a hydrogen atom or a hydrocarbon group having 1 to 3 carbon atoms; and * represents a bond.

In the photosensitive resin composition for the original flexographic printing plate of the present embodiment, by containing the ethylenically unsaturated compound (B-2) having the specific structure shown in the formula (4), the impact of oxygen inhibition on the surface of the original flexographic printing plate is suppressed by the ethylenically unsaturated compound (B-2), and the formability of highlight dots at the time of low-illuminance exposure tends to be improved.

The ethylenically unsaturated compound (B-2) having the structure represented by the formula (4) exerts an effect of suppressing oxygen inhibition by the reaction mechanism described later. That is, the hydrogen atom bound to the carbon atom at the α position of the vinyl group of the ethylenically unsaturated compound (B-2) is pulled out by a peroxide radical generated from oxygen in the air to form an allyl radical intermediate. This allyl radical intermediate has a high vinyl group reactivity and promotes the curing reaction, so that the impact of oxygen inhibition by the peroxide radical generated from oxygen in the air can be counteracted. Thus, the photosensitive resin composition layer (b) constituting the original flexographic printing plate of the present embodiment contains the ethylenically unsaturated compound (B-2), which suppresses the defective dot formation caused by oxygen inhibition and tends to improve the formability of highlight dots at the time of low-illuminance exposure.

Examples of such an ethylenically unsaturated compound (B-2) include diallyl diphenate and Diprenyl Glycerin Ether.

Among them, from the viewpoint of the dot formability at the time of low-illuminance exposure of the original flexographic printing plate of the present embodiment, it is preferable to contain Diprenyl Glycerin Ether represented by the following formula (5) as the ethylenically unsaturated compound (B-2):

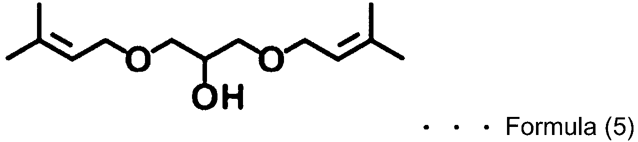

From the viewpoint of the dot formability at the time of low-illuminance exposure of the original flexographic printing plate of the present embodiment, the content of the ethylenically unsaturated compound (B-2) is preferably 0.1% by mass or more and 5% by mass or less, more preferably 1% by mass or more and 3% by mass or less, and further preferably 1.5% by mass or more and 3% by mass or less based on the total amount of the photosensitive resin composition layer (b) of 100% by mass.

Examples of the ethylenically unsaturated compound (b-2) other than the ethylenically unsaturated compound (B-2) include, but are not limited to, olefins such as ethylene, propylene, 4-vinyltoluene, styrene, 1,2-divinylbenzene, 1,3-divinylbenzene, and 1,4-divinylbenzene; acetylenes; (meth)acrylic acid and/or derivatives thereof; haloolefins; unsaturated nitriles such as acrylonitrile; unsaturated amides such as acrylamide or methacrylamide, and derivatives thereof; unsaturated dicarboxylic acids such as maleic anhydride, maleic acid, and fumaric acid and derivatives thereof; vinyl acetates; N-vinylpyrrolidone; N-vinylcarbazole; and N-substituted maleimide compounds.

Among these, from the viewpoint of ultraviolet ray curability and printing durability of the photosensitive resin composition layer (b) after curing, it is preferable to contain (meth)acrylic acid and/or derivatives thereof as the ethylenically unsaturated compound (b-2).

Examples of each of the derivatives include, but are not limited to, an alicyclic compound having a cycloalkyl group, a bicycloalkyl group, a cycloalkenyl group, a bicycloalkenyl group, or the like; an aromatic compound having a benzyl group, a phenyl group, a phenoxy group, a naphthalene skeleton, an anthracene skeleton, a biphenyl skeleton, a phenanthrene skeleton, a fluorene skeleton, or the like; a compound having an alkyl group, a halogenated alkyl group, an alkoxyalkyl group, a hydroxyalkyl group, an aminoalkyl group, a glycidyl group, or the like; an ester compound with a polyhydric alcohol such as an alkylene glycol, a polyoxyalkylene glycol, a polyalkylene glycol, or trimethylolpropane; and a compound having a polysiloxane structure, such as polydimethylsiloxane and polydiethylsiloxane.

In addition, the ethylenically unsaturated compound (b-2) may be a heteroaromatic compound containing an element such as nitrogen or sulfur.

Examples of the (meth)acrylic acid and/or derivatives thereof include, but are not limited to, a diacrylate and a dimethacrylate of an alkanediol such as 1,6-hexanediol or 1,9-nonanediol; a diacrylate and a dimethacrylate of ethylene glycol, diethylene glycol, propylene glycol, dipropylene glycol, polyethylene glycol, or butylene glycol; trimethylolpropane tri(meth)acrylate; dimethylol tricyclodecane di(meth)acrylate; isobornyl (meth)acylate; phenoxy polyethylene glycol (meth)acrylate; and pentaerythrit tetra(meth)acrylate.

These may be used singly or in combinations of two or more thereof.

From the viewpoint of the mechanical strength of a flexographic printing plate produced using the original flexographic printing plate according to the present embodiment, at least one (meth)acrylate is preferably used, and at least one bifunctional (meth)acrylate is more preferably used as the ethylenically unsaturated compound (b-2).

The number average molecular weight (Mn) of the ethylenically unsaturated compound (b-2) is preferably 100 or more from the viewpoint of improving nonvolatility of the ethylenically unsaturated compound (b-2) during production and/or storage of the original flexographic printing plate according to the present embodiment, preferably less than 1000 from the viewpoint of compatibility with the other components, and more preferably 200 or more and 800 or less.

From the viewpoint of the printing durability of the flexographic printing plate obtained using the original flexographic printing plate of the present embodiment, the content of the ethylenically unsaturated compound (b-2) in the photosensitive resin composition layer (b) is preferably 2% by mass or more and 30% by mass or less, more preferably 2% by mass or more and 25% by mass or less, and further preferably 2% by mass or more and 20% by mass or less based on the total amount of the photosensitive resin composition layer (b) of 100% by mass.

### <Photopolymerization Initiator (b-3)>

The photosensitive resin composition layer (b) preferably contains a photopolymerization initiator (b-3). The photopolymerization initiator (b-3) is a compound that absorbs the energy of light to produce a radical and includes a degradable photopolymerization initiator, a hydrogen abstraction type photopolymerization initiator, and a compound having a site functioning as a hydrogen abstraction type photopolymerization initiator and a site functioning as a degradable photopolymerization initiator in the same molecule.

Examples of the photopolymerization initiator (b-3) include, but are not limited to, benzophenones such as benzophenone, 4,4-bis(diethylamino)benzophenone, 3,3',4,4'-benzophenone tetracarboxylic anhydride, and 3,3',4,4'-tetramethoxy benzophenone; anthraquinones such as 2-t-butyl anthraquinone and 2-ethyl anthraquinone; thioxanthones such as 2,4-diethyl thioxanthone, isopropyl thioxanthone, and 2,4-dichloro thioxanthone; Michler's ketone; acetophenones such as 2,2-diethoxyacetophenone, 2,2-dimethoxy-2-phenylacetophenone, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, 2-methyl-1-(4-methylthiophenyl)-2-morpholino-propan-1-one, 2-benzyl-2-dimethylamino-1-(4-morpholinophenyl)-butanone, and trichloroacetophenone; benzoin ethers such as benzoin methyl ether, benzoin ethyl ether, benzoin isopropyl ether, and benzoin isobutyl ether; acylphosphine oxides such as 2,4,6-trimethylbenzoyl diphenyl phosphine oxide, bis(2,6-dimethoxybenzoyl)-2,4,4-trimethyl pentyl phosphine oxide, and bis(2,4,6-trimethylbenzoyl)-phenyl phosphine oxide; methyl benzoylformate; 1,7-bisacridinyl heptane; 9-phenyl acridine; and azo compounds such as azobisisobutyronitrile, diazonium compounds, and tetrazene compounds.

These may be used singly or in combinations of two or more thereof.

Among these, in view of the hardness of the flexographic printing plate produced using the original flexographic printing plate according to the present embodiment, the photopolymerization initiator (b-3) is preferably a compound having a carbonyl group, and more preferably an aromatic carbonyl compound such as benzophenones or thioxanthones.

When the content of the photopolymerization initiator (b-3) in the photosensitive resin composition layer (b) decreases, excessive halftone dot formation when the plate is made with high-illuminance exposure of the original flexographic printing plate of the present embodiment is suppressed. When the content of the photopolymerization initiator (b-3) increases, the formability of the flexographic printing plate is improved, thus the defective dot formation when the plate is made with low-illuminance exposure is suppressed. From the viewpoint of compatibility of dot formability at the time of low-illuminance exposure and at the time of high-illuminance exposure, the content of the photopolymerization initiator (b-3) in the photosensitive resin composition layer (b) is preferably 0.1% by mass or more and 10.0% by mass or less, more preferably 0.5% by mass or more and 5.0% by mass or less, and further preferably 1.0% by mass or more and 5.0% by mass or less based on the total amount of the photosensitive resin composition layer (b) of 100.0% by mass.

### <Liquid Diene (b-4)>

The photosensitive resin composition layer (b) preferably contains a liquid diene.

The liquid diene is a liquid compound having a carbon-carbon double bond.

In the present specification, "liquid" in the "liquid diene" means a characteristic having the property of being easily flow-deformable and capable of being solidified into a deformed shape by cooling. The liquid diene is a term corresponding to an elastomer that has a property in which, when an external force is applied, deformation occurs instantly depending on the external force, and when the external force is removed, the original shape is recovered in a short time.

The liquid diene can be distinguished from the thermoplastic elastomer (b-1) in that it flows and deforms even at room temperature, and distinguished from the ethylenically unsaturated compound (b-2) in that it is a copolymer containing 50% by mass or more diene components.

Examples of the liquid diene (b-4) include, but are not limited to, liquid polybutadiene, liquid polyisoprene, a modified product of liquid polybutadiene, a modified product of liquid polyisoprene, a liquid acrylonitrile-butadiene copolymer, and a liquid styrene-butadiene copolymer.

The liquid diene is defined as a copolymer having a diene component of 50% by mass or more.

Among these, the liquid diene is preferably liquid polybutadiene from the viewpoint of mechanical properties of the original flexographic printing plate of the present embodiment and the flexographic printing plate produced using the same.

The amount of 1,2-vinyl bond in the liquid diene, preferably liquid polybutadiene, is preferably 1% or more and 80% or less, more preferably 5% or more and 70% or less, and still more preferably 5% or more and 65% or less from the viewpoint of making the hardness of the original flexographic printing plate according to the present embodiment, and the hardness of a flexographic printing plate produced using the same appropriate.

"The amount of the 1,2-vinyl bond" is a proportion of a conjugated diene monomer incorporated by a 1,2-bond in conjugated diene monomers incorporated by bonding forms of the 1,2-bond, 3,4-bond, and a 1,4-bond. The amount of the 1,2-vinyl bond can be determined from the peak ratio of the ¹H-NMR (magnetic resonance spectrum) of liquid polybutadiene.

1,2-Polybutadiene, which is the liquid polybutadiene having the 1,2-vinyl bond, is highly reactive in radical polymerization and is preferable from the viewpoint of enhancing the hardness of the photosensitive resin composition layer (b) because vinyl, which has a double bond, forms a side chain.

The liquid polybutadiene is usually a mixture of 1,2-polybutadiene having a 1,2-vinyl bond and 1,4-polybutadiene having a 1,4-vinyl bond. It is preferable that 1,4-polybutadiene is contained in the liquid diene from the viewpoint of improving the flexibility of the original flexographic printing plate of the present embodiment and the flexographic printing plate produced using this. 1,4-Polybutadiene includes cis-1,4-polybutadiene and trans-1,4-polybutadiene. Any of cis- and trans-1,4-polybutadiene has a low reactivity in radical polymerization because a vinyl group, which has a double bond, exists inside, so that a soft resin can be produced ultimately.

When a plurality of liquid polybutadienes each having a different amount of the 1,2-vinyl bond are mixed and used, the average value of the amounts is defined as the amount of the 1,2-vinyl bond.

From the viewpoint of capable of adjusting the reactivity of the photosensitive resin composition layer (b) easily, the whole amount of the 1,2-vinyl bond is preferably adjusted by mixing liquid polybutadiene having an amount of the 1,2-vinyl bond of 10% or less and liquid polybutadiene having an amount of the 1,2-vinyl bond of 80% or more. The whole amount of the 1,2-vinyl bond is preferably adjusted by mixing liquid polybutadiene having an amount of the 1,2-vinyl bond of 5% or less and liquid polybutadiene having an amount of the 1,2-vinyl bond of 80% or more, more preferably.

The number average molecular weight of the liquid diene (b-4) is not particularly limited as long as it is liquid at 20°C, but is preferably 500 or more and 60000 or less, more preferably 500 or more and 50000 or less, and still more preferably 800 or more and 50000 or less from the viewpoint of the printing durability and handling properties of a flexographic printing plate produced using the original flexographic printing plate according to the present embodiment.

From the viewpoint of the printing durability of the original flexographic printing plate of the present embodiment and the flexographic printing plate produced using this, the content of the liquid diene (b-4) in the photosensitive resin composition layer (b) is preferably 10% by mass or more and 40% by mass or less, more preferably 15% by mass or more and 40% by mass or less, and further preferably 20% by mass or more and 40% by mass or less based on the total amount of the photosensitive resin composition layer (b) of 100% by mass.

### <Stabilizer (b-5)>

The photosensitive resin composition layer of the original flexographic printing plate of the present embodiment preferably contains a stabilizer (b-5).

The stabilizer (b-5) refers to a component contained in the photosensitive resin composition layer (b) to prevent deterioration and gelation during the production or storage of the original flexographic printing plate, such as a thermal polymerization inhibitor or an antioxidant.

From the viewpoint of compatibility of the formability of highlight dot portion at the time of low-illuminance exposure and the suppression of excessive halftone dot formation at the time of high-illuminance exposure, the amount of heat generation at the heat generation peak of photo-DSC in the photosensitive resin composition layer (b) of the original flexographic printing plate of the present embodiment is specified to a predetermined numerical range.

By containing at least one stabilizer of compounds represented by the following formula (2) or (3) (hereinafter referred to as stabilizer (B-5)) as part or all of the stabilizer (b-5), the time to the heat generation peak and the amount of heat generation at the peak top of the photosensitive resin composition layer (b) tend to be possible to be controlled.

The photosensitive resin composition layer (b) of the original flexographic printing plate of the present embodiment preferably contains at least one stabilizer (B-5) as the stabilizer (b-5), from the viewpoint of stability at the time of production and storage, and compatibility of dot formability at the time of low-illuminance exposure and at the time of high-illuminance exposure.

It should be noted that the stabilizer (B-5), which is a compound represented by the following formula (2) or (3), may be all or part of the stabilizer (b-5): 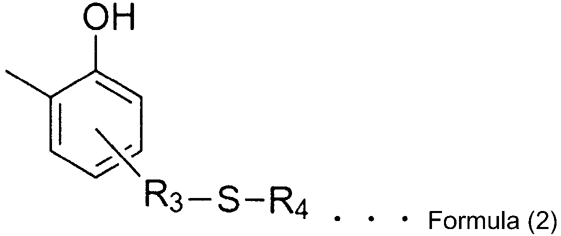 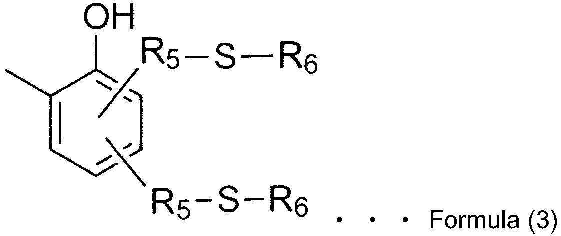 wherein, R₃ and R₅ each independently represent an alkyl group having 1 to 4 carbon atoms; and R₄ and R₆ each independently represent an alkyl group having 1 to 12 carbon atoms.

When the content of the stabilizer (b-5) in the photosensitive resin composition layer (b) increases, the production stability of the flexographic printing plate is improved. However, many of the stabilizers (b-5) consume reactive radicals in the curing reaction at the time of exposure, thus reduces the formability of the flexographic printing plate.

When the photosensitive resin composition layer (b) contains at least one of the stabilizer (B-5) as part or all of the stabilizer (b-5), the stability at the time of production and storage of the original flexographic printing plate of the present embodiment is guaranteed, and the formability of the flexographic printing plate at the time of low-illuminance exposure tends to be improved.

The stabilizer (B-5) has a phenolic structure and a sulfur atom in one molecule, and exerts a high-efficiency stabilization effect by the synergistic effect of the phenol-based antioxidant and the sulfur-based antioxidant. Furthermore, since the stabilizer (B-5) contains an alkyl group in the molecule and is thus excellent in dispersion in the photosensitive resin composition layer (b), it can exert a more efficient stabilizing effect than other sulfur-based stabilizers. Furthermore, since the sulfur-based antioxidant decomposes peroxides, the generation of peroxide radicals, which are one of the reaction species that causes oxygen inhibition in the formability of the flexographic printing plate at the time of low-illuminance exposure, can be prevented. Furthermore, since the sulfur atom in the molecule has a covalent bond with the alkyl group, the electron donation of sulfur is improved, and thus peroxide radicals are easily decomposed, the effect of suppressing oxygen inhibition at the time of low-illuminance exposure becomes high, and the dot formability can be further improved.

Due to these properties, the original flexographic printing plate of the present embodiment can reduce the impact of oxygen inhibition at the time of low-illuminance exposure and improves the formability of the flexographic printing plate by containing at least one of the stabilizer (B-5) in the photosensitive resin composition layer (b).

From the viewpoint of the dot formability at the time of low-illuminance exposure of the flexographic printing plate obtained using the original flexographic printing plate of the present embodiment, the content of the stabilizer (B-5) is preferably 0.45% by mass or less, more preferably 0.10% by mass or more and 0.45% by mass or less, and further preferably 0.30% by mass or more and 0.40% by mass or less based on the total amount of the photosensitive resin composition layer (b) of 100% by mass.

From the same viewpoint, the ratio of the stabilizer (B-5) is preferably 60% by mass or more and 100% by mass or less, more preferably 80% by mass or more and 100% by mass or less, and further preferably 90% by mass or more and 100% by mass or less based on the total amount of the stabilizer (b-5) contained in the photosensitive resin composition layer (b) of 100% by mass.

From the viewpoint of compatibility of dot formability at the time of low-illuminance exposure and at the time of high-illuminance exposure, the ratio of the amount of the stabilizer (B-5) contained in the photosensitive resin composition layer (b) is preferably 1 part by mass or more and 50 parts by mass or less, more preferably 5 parts by mass or more and 30 parts by mass or less, and further preferably 10 parts by mass or more and 15 parts by mass or less based on the amount of the photopolymerization initiator (b-3) contained in the photosensitive resin composition layer (b) of 100% by mass.

As the stabilizer (b-5) other than the stabilizer (B-5), those usually used in the field of resin materials or rubber materials can be used. Specific examples include a phenol-based material.

Examples of the phenol-based material include, but are not limited to, vitamin E, tetrakis-(methylene-3-(3',5'-di-t-butyl-4'-hydroxyphenyl)propionate)methane, 2,5-di-t-butylhydroquinone, 2,6-di-t-butyl-p-cresol, and 2-t-butyl-6-(3-t-butyl-2-hydroxy-5-methylbenzyl)-4-methylphenyl acrylate.

The stabilizer (b-5), such as a thermal polymerization inhibitor and an antioxidant, may be used singly or in combinations of two or more thereof.

### <Dye (b-6)>

The original flexographic printing plate of the present embodiment preferably contains a dye (b-6) in the photosensitive resin composition layer (b).

The dye (b-6) refers to a component contained in the photosensitive resin composition layer (b) as a coloring means for improving visibility.

From the viewpoint of compatibility of the formability of the highlight dot portion at the time of low-illuminance exposure and the suppression of excessive halftone dot formation at the time of high-illuminance exposure, the amount of heat generation at the heat generation peak of photo-DSC in the photosensitive resin composition layer (b) of the original flexographic printing plate of the present embodiment is specified to a predetermined numerical range.

By containing a dye having a 1,4-diamino-5,8-dihydroxyanthraquinone backbone in the molecular structure (hereinafter referred to as dye (B-6)) as part or all of the dye (b-6), the heat generation behavior of the photosensitive resin composition layer (b) tends to be possible to be controlled.

It is known that 1,4-diamino-5,8-dihydroxyanthraquinone forms a hydrogen bond between the carbonyl oxygen atom and a hydrogen atom of the amino group, and between the carbonyl oxygen atom and a hydrogen atom of the hydroxy group, respectively. These interactions further lead to interactions among each component in the photosensitive resin composition (b), such as ethylene monomers, the photopolymerization initiator, and the stabilizer. The dye (B-6) having the 1,4-diamino-5,8-dihydroxyanthraquinone backbone in the molecular structure has an effect of relieving the reactivity of the photopolymerization initiator in the photosensitive resin composition layer (b) by such interactions, so that rapid radical generation can be suppressed. Furthermore, since it has absorbance in the UV region, it exerts the effect especially when exposed with a high-illuminance exposure machine, and tends to be capable of suppressing excessive halftone dot formation.

From the viewpoint of improving the dispersion in the photosensitive resin composition layer (b) and effectively exerting the effect, it is more preferable that the dye (B-6) having the 1,4-diamino-5,8-dihydroxyanthraquinone backbone is a dye having the molecular structure shown in the following formula (1) (hereinafter referred to as dye (B-6')): 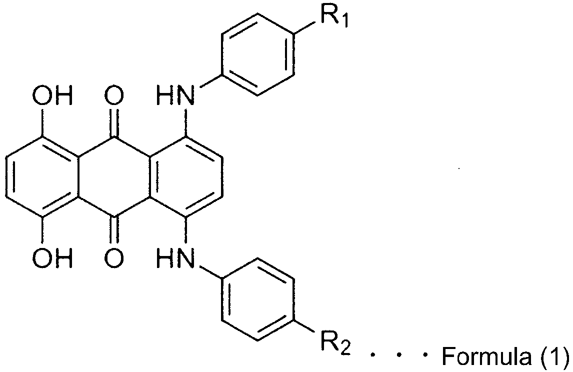 wherein, R₁ and R₂ each independently represent an alkyl group having 1 to 4 carbon atoms.

From the viewpoint of controlling the heat generation behavior of the photo-DSC, the content of the dye (B-6') in the photosensitive resin composition layer (b) is preferably 0.005% by mass or more and 0.1% by mass or less, more preferably 0.009% by mass or more and 0.05% by mass or less, and further preferably 0.009% by mass or more and 0.03% by mass or less.

Examples of the dye (b-6) other than the dye (B-6) include, but are not limited to, a basic dye, an acidic dye, and a direct dye, which are water-soluble, and a sulfur dye, an oil-soluble dye, and a disperse dye, which are non-water-soluble. The dye (b-6) may include an anthraquinone-based dye, an indigoid-based dye, an azo-based dye, an azo-based oil-soluble dye, and the like.

### <Auxiliary Additive Component>

The original flexographic printing plate of the present embodiment may contain a predetermined auxiliary addition component in addition to the various components described above in the photosensitive resin composition layer (b).

Examples of the auxiliary additive component include, but are not limited to, a polar group-containing polymer, a plasticizer other than liquid diene, an ultraviolet absorber, and a pigment.

Examples of the polar group-containing polymer include, but are not limited to, a water-soluble or water-dispersible copolymer having a hydrophilic group such as a carboxyl group, an amino group, a hydroxyl group, a phosphoric acid group, and a sulfonic acid group, and a polar group such as a salt thereof. More specific examples include an acrylonitrile-butadiene rubber containing a carboxyl group, a styrene-butadiene rubber containing a carboxyl group, a polymer of an aliphatic conjugated diene containing a carboxyl group, an emulsified polymer of an ethylenically unsaturated compound having a phosphate group or a carboxyl group, a sulfonic acid group-containing polyurethane, and a carboxyl group-containing butadiene latex. These polar group-containing polymers may be used singly or in combinations of two or more thereof.

Among these, from the viewpoint of obtaining a high resolution in the flexographic printing plate using the original flexographic printing plate of the present embodiment, the carboxyl group-containing butadiene latex is preferred as the polar group-containing polymer.

Examples of the plasticizer other than liquid diene include, but are not limited to, a hydrocarbon oil such as a naphthenic oil and a paraffinic oil; a conjugated diene rubber mainly composed of a liquid diene, such as a liquid acrylonitrile-butadiene copolymer and a liquid styrene-butadiene copolymer; a polystyrene having a number average molecular weight of 2000 or less, and an ester-based plasticizer such as a sebacic acid ester and a phthalic acid ester.

The other plasticizers other than liquid diene described above may have a hydroxyl group or a carboxyl group. In addition, the other plasticizers described above may have a photopolymerizable reaction group such as a (meth)acryloyl group.

The other plasticizers described above may be used singly or in combinations of two or more thereof.

Examples of the ultraviolet ray absorber include, but are not limited to, known benzophenone-based, salicylate-based, acrylonitrile-based, metal complex-based, or hindered amine-based compounds.

The dye or pigment described below may also be used as the ultraviolet ray absorber.

Examples of the ultraviolet ray absorber include, but are not limited to, 2-ethoxy-2'-ethyloxalic acid bisanilide, and 2,2'-dihydroxy-4-methoxybenzophenone.

The pigment is effective as coloring means for improving visibility.

Examples of the pigment include, but are not limited to, a natural pigment, a synthetic inorganic pigment, and a synthetic organic pigment.

Examples of the synthetic organic pigment include an azo-based pigment, a triphenylmethane-based pigment, a quinoline-based pigment, an anthraquinone-based pigment, and a phthalocyanine-based pigment.

The total amount of the above-described auxiliary additive components to be added is preferably 0% by mass or more and 10% by mass or less, more preferably 0% by mass or more and 5% by mass or less, and further preferably 0% by mass or more and 3% by mass or less based on the total amount of the photosensitive resin composition layer (b) of 100% by mass.

### (Infrared Ray Ablation Layer (c))

The original flexographic printing plate of the present embodiment may comprise an infrared ray ablation layer (c) containing an infrared ray sensitive substance, which is laminated on the photosensitive resin composition layer (b).

The infrared ray ablation layer (c) preferably contains a binder polymer, an infrared ray sensitive substance, and a non-infrared radiation shielding substance.

Examples of the binder polymer include, but are not limited to, a polyamide, a polyester, and a copolymer consisting of a monovinyl-substituted aromatic hydrocarbon and a conjugated diene. Among them, a copolymer consisting of a monovinyl-substituted aromatic hydrocarbon such as styrene, α-methylstyrene, vinyltoluene, and a conjugated diene such as 1,3-butadiene or isoprene is preferred.

When the infrared ray ablation layer (c) is composed using the binder polymer, the affinity with the photosensitive resin composition tends to be high and the adhesion tends to be good.

As the infrared ray-sensitive substance, for example, a single substance or compound having strong absorption, usually in the range of 750 to 2000 nm, is preferably used.

Specific examples of the infrared ray-sensitive substance include inorganic pigments such as carbon black, graphite, copper chromite, and chromium oxide; and dyes such as polyphthalocyanine compounds, cyanine dyes, and metal thiolate dyes.

These infrared ray sensitive substances are added in the infrared ray ablation layer (c) to the extent that they confer a sensitivity that can be removed with the laser beam used. Generally, an addition amount of 10 to 80% by mass is preferred.

As the non-infrared radiation shielding substance, a substance that reflects or absorbs radiation such as ultraviolet rays can be used. Preferred examples thereof include a radiation absorber such as ultraviolet rays, and carbon black, and graphite. The addition amount thereof is set so that the required optical density can be achieved. It is generally preferred that the non-infrared radiation shielding substance is added such that the optical density is 2 or more, preferably 3 or more.

### [Method for Producing Flexographic Printing Plate]

The method for producing a flexographic printing plate of the present embodiment, using the original flexographic printing plate of the present embodiment, includes: a first step of performing ultraviolet ray irradiation from the support (a) side; a second step of laser-ablating an infrared ray ablation layer (c) provided on the photosensitive resin composition layer (b) with irradiation of infrared ray to form a negative pattern; a third step of irradiating the photosensitive resin composition layer (b) with an ultraviolet ray for pattern exposure using, as a mask, the infrared ray ablation layer (c) on which the pattern is drawn and processed; and a fourth step of removing an unexposed portion of the photosensitive resin composition layer (b).

If necessary, the step of performing a post-exposure treatment is then performed to obtain a flexographic printing plate (letterpress printing plate) formed from a cured photosensitive resin composition layer (b).

The surface of the flexographic printing plate may be brought into contact with a liquid containing a silicone compound and/or a fluorine compound from the viewpoint of conferring peeling properties from the flexographic printing plate and the ink in the printing process.

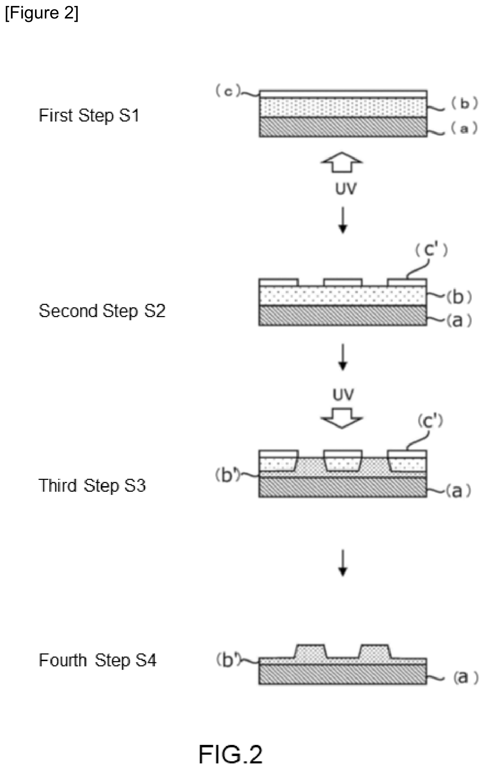

Figure 2 shows a schematic diagram illustrating a method for producing a flexographic printing plate using an original flexographic printing plate according to the present embodiment. Hereinafter, each step is described in detail.

### (First Step: S1)

In the first step, the method of performing ultraviolet ray irradiation to the photosensitive resin composition layer (b) from a side of the support (a) is not particularly limited, and can be carried out using a known irradiation unit. The wavelength of ultraviolet ray in the irradiation is preferably 150 to 500 nm, more preferably 300 to 400 nm.

The light source of the ultraviolet ray is not limited to the following, but, for example, a low-pressure mercury lamp, a high-pressure mercury lamp, an ultrahigh-pressure mercury lamp, a metal halide lamp, a xenon lamp, a zirconium lamp, a carbon arc lamp, or a fluorescent lamp for ultraviolet ray can be used.

This first step may be performed before or after the second step described later.

### (Second Step: S2)

In the second step, the method for drawing and processing a pattern on the infrared ray ablation layer (c) by infrared ray irradiation is not particularly limited, and can be carried out using a known irradiation unit. The irradiation of infrared ray to the infrared ray ablation layer (c) can be carried out from the side of the infrared ray ablation layer (c).

When the original flexographic printing plate according to the present embodiment has a cover film, the cover film is first peeled off before the infrared ray irradiation. The infrared ray ablation layer (c) is then pattern-irradiated with an infrared ray to decompose the resin of the irradiated part of the infrared ray, and the pattern is drawn and processed. This makes it possible to form a mask (c') of the infrared ray ablation layer (c) on the photosensitive resin composition layer (b).

In the second step, suitable examples of the infrared laser include ND/YAG laser (for example, 1064 nm) or diode laser (for example, 830 nm). Laser systems suitable for CTP plate making techniques are sold on the market, and, for example, a diode laser system CDI Spark (Esko-Graphics BV.) can be used. This laser system includes: a rotary cylindrical drum that holds the original flexographic printing plate according to the present embodiment; IR laser irradiation apparatus; and a layout computer, and image information is directly sent from the layout computer to the laser apparatus.

### (Third Step: S3)

In the third step, the photosensitive resin composition layer (b) is irradiated with an ultraviolet ray for pattern exposure using the infrared ray ablation layer (c) on which the pattern is drawn and processed as a mask to form a printing pattern (b'). At this time, the light passing through the mask promotes a curing reaction in the photosensitive resin composition layer (b), and a pattern formed in the infrared ray ablation layer (c) is transferred to the photosensitive resin composition layer (b) in which the convex and concave are inverted. Ultraviolet ray irradiation may be performed on the whole surface of the original flexographic printing plate according to the present embodiment.

The third step can be carried out in a state where the original flexographic printing plate according to the present embodiment is attached to a laser cylinder, but is generally performed by taking the original flexographic printing plate according to the present embodiment out of a laser apparatus, and irradiating using a conventional irradiation unit. The same irradiation unit as the one illustrated in the ultraviolet ray irradiation in the first step can be used as the irradiation unit.

### (Fourth Step: S4)

The fourth step is a step of removing the infrared ray ablation layer (c) and an unexposed portion of the photosensitive resin composition layer (b).

In the fourth step (the developing step), the removing method is not particularly limited, and a conventionally known method can be applied.

Specifically, as described above, the photosensitive resin composition layer (b) of the original flexographic printing plate of the present embodiment is exposed to form a printing pattern (b'), and then the unexposed portions can be washed with a solvent for solvent development or a washing solution for water development to remove the unexposed portions. The unexposed portion can also be removed by, for example, heating the unexposed portions to 40°C to 200°C and contacting with a predetermined absorbent layer that can absorb the heated unexposed portions, that is, by performing heat development.

If necessary, a post-exposure treatment is then performed, thereby producing a flexographic printing plate.

When an intermediate layer (d) is located between the infrared ray ablation layer (c) and the photosensitive resin composition layer (b), the intermediate layer (d) may be removed simultaneously in the developing step.

Examples of the solvent for development used for performing solvent development on the unexposed portions include, but are not limited to, esters such as heptyl acetate and 3-methoxybutyl acetate; hydrocarbons such as petroleum fractions, toluene, and decaline; and mixtures obtained by mixing an alcohol such as 1-propanol, 2-propanol, 1-butanol, or 1-pentanol with a chlorine-based organic solvent such as tetrachloroethylene. The washing of the unexposed portion is performed by injection from the nozzle or by brushing with a brush.

As the washing solution for water development, water, an alkaline aqueous solution, a neutral detergent, and a surfactant can be suitably used.

Examples of the surfactant include an anionic surfactant, an amphoteric surfactant, and a nonionic surfactant. These may be used singly or as mixtures of two or more thereof.

Examples of the anionic surfactant include, but are not limited to, a sulfuric acid ester salt, a higher alcohol sulfuric acid ester, a higher alkyl ether sulfuric acid ester salt, a sulfated olefin, an alkylbenzenesulfonate, an α-olefinsulfonate, a phosphoric acid ester salt, and dithiophosphoric acid ester salt.

Examples of the amphoteric surfactant include, but are not particularly limited to, an amino acid type amphoteric surfactant and a betaine type amphoteric surfactant.

Examples of the nonionic surfactant include, but are not limited to, polyethylene glycol type surfactants such as an ethylene oxide adduct of a higher alcohol, an ethylene oxide adduct of an alkylphenol, an ethylene oxide adduct of an aliphatic acid, an ethylene oxide adduct of a polyhydric alcohol aliphatic acid ester, an ethylene oxide adduct of a higher alkylamine, an ethylene oxide adduct of an aliphatic acid amide, and an ethylene oxide adduct of polypropylene glycol, and polyhydric alcohol type surfactants such as an aliphatic acid ester of glycerol, an aliphatic acid ester of pentaerythritol, an aliphatic acid ester of sorbitol and of sorbitan, an alkyl ether of a polyhydric alcohol, and an aliphatic acid amide of an alkanolamine.

For the alkaline aqueous solution, a pH modifier may be contained. The pH modifier may be any of organic materials and inorganic materials, and preferably enables pH to be adjusted to 9 or higher. Examples of the pH modifier include, but are not limited to, sodium hydroxide, sodium carbonate, potassium carbonate, sodium silicate, sodium metasilicate, and sodium succinate.

Examples of the absorption layer of heat development include, but are not particularly limited to, a nonwoven fabric material, a paper material, a fiber fabric, an open-celled foam, and a porous material. Among these, a non-woven fabric material consisting of nylon, polyester, polypropylene, or polyethylene, and a combination of these non-woven fabric materials are preferred, and a continuous web of non-woven fabric of nylon or polyester is more preferred.

### Examples

Hereinafter, the present embodiment will be described more specifically with reference to specific Examples and Comparative Examples, but the present invention is not limited to the following Examples and Comparative Examples by any means.

Regarding Examples and Comparative Examples described later, the methods for measuring physical properties are shown below.

### [Time from Irradiation by Photo-DSC to Heat Generation Peak and Amount of heat generation at Peak Top]

The measurement value of photo-DSC was determined by the following measurement method.

DSC-7000X manufactured by Hitachi High-Tech Corporation was used as the DSC measurement device. An photo-DSC measurement unit was attached to the device and set so that the DSC measurement could be performed while irradiating with a light.

The light source for light irradiation was LA-410 UV manufactured by HAYASHI-REPIC CO., LTD., where a light of 365 nm wavelength could be extracted with a bandpass filter to irradiate a sample.

The measurement was performed under air circulation, and the circulation speed was 50 mL/min.

The photosensitive resin composition sample of 0.5 mm thickness obtained in the <Preparation of Sample for Photo-DSC Measurement> described later was punched into a circle with a diameter of 7 mm, and the obtained photosensitive resin composition sample in an amount of about 18 mg was placed in a dedicated aluminum pan, and irradiated with a light of 365 nm wavelength at illuminance of 10 mW/cm², and the heat generation behavior was measured at a temperature of 25°C with a data acquisition interval of 0.1 seconds for 10 minutes from the start of irradiation.

At this time, the amount of heat generation was plotted on the horizontal axis in time (seconds) and the vertical axis in µW, and the time from the start of irradiation to the peak top and the value of the amount of heat generation at the peak top divided by mass (unit: µW/mg) were calculated.

The measurement results are shown in Tables 1 to 3.

### [Production Examples]

### (Preparation of Laminate for Forming Infrared Ray Ablation Layer)

100 parts by mass of carbon black (CB) as an infrared ray absorber, 20 parts by mass of Solsperse 39000 (manufactured by Japan Lubrizol corporation, trade name, base value 30 mg KOH/g) as a dispersant, 80 parts by mass of TUFTEC H1051 (manufactured by Asahi Kasei Corporation, trade name), which is a hydrogen additive of a styrene-butadiene-styrene copolymer elastomer, as a binder polymer, and 600 parts by mass of toluene were mixed to obtain an infrared ray ablation layer coating solution.

This infrared ray ablation layer coating solution was applied to coat a PET film having a thickness of 100 µm as a cover film so that the film thickness after drying was 3 µm, and a drying treatment was performed at 90°C for 2 minutes to obtain a laminate for forming an infrared ray ablation layer, which was a laminate of the infrared ray ablation layer and the cover film.

### (Preparation of Support)

As a solution for the adhesive layer to be coated on the support, 55 parts by mass of Tufprene 912 (manufactured by Asahi Kasei Corporation, trade name), which is a block copolymer of styrene and 1,3-butadiene, 38 parts by mass of paraffin oil (average number of carbons 33, average molecular weight 470, density 0.868 at 15°C), 2.5 parts by mass of 1,9-nonanediol diacrylate, 1.5 parts by mass of 2,2-dimethoxy-phenylacetophenone, 3 parts by mass of epoxy ester 3000M (manufactured by KYOEISHA CHEMICAL Co., LTD., trade name), and 1.5 parts by mass of VALIFAST YELLOW 3150 (manufactured by ORIENT CHEMICAL INDUSTRIES CO., LTD., trade name) were dissolved in toluene to obtain a solution with a solid content of 25%.

Subsequently, the solution was applied on one side of a polyester film of 100 µm thick using a knife coater at ultraviolet ray transmittance (UV transmittance) of 10% and dried at 80°C for 1 minute to obtain a support having an adhesive layer.

The UV transmittance of the support was calculated by using the ultraviolet ray exposure machine AFP-1500 (manufactured by Asahi Kasei Corporation, trade name) and measuring the transmittance intensity with a UV illuminance meter MO-2 type machine (manufactured by ORC MANUFACTURING CO., LTD., trade name, UV-35 filter).

### (Production of Photosensitive Resin Composition)

### <Production of Photosensitive Resin Composition 1>

67.5 parts by mass of styrene-butadiene-styrene copolymer [D-KX405: manufactured by Kraton Corporation], 21.5 parts by mass of liquid polybutadiene [LBR-352: manufactured by Kuraray Co., Ltd.], 9.0 parts by mass of 1,9-nonanediol diacrylate, 2.0 parts by mass of 1,6-hexanediol dimethacrylate, 2.2 parts by mass of Diprenyl Glycerin Ether [DPNG: manufactured by Kuraray Co., Ltd.], 4.0 parts by mass of photopolymerization initiator [2,2-dimethoxy-2-phenylacetophenone: manufactured by BASF SE], 0.4 parts by mass of 2,4-bis[(octylthio)methyl]-o-cresol [Irganox 1520 L: manufactured by BASF SE] as a stabilizer, and 0.01 parts by mass of 1,4-bis[(4-t-butylphenyl)amino]-5,8-dihydroxy-9,10-anthraquinone [C.I. Solvent Green 28: manufactured by Nippon Kayaku Co., Ltd.] as a dye were kneaded with a pressure kneader to prepare photosensitive resin composition 1 (referred to as resin 1 in Table 1).

### <Production of Photosensitive Resin Compositions 2 to 28>

The photosensitive resin compositions 2 to 28 (referred to as resins 2 to 28 in Tables 1 to 3) were obtained in the same manner as the photosensitive resin composition 1 except that the composition was changed as shown in Tables 1 to 3 below.

Each material in Tables 1 to 3 is shown below.
LIR-305: liquid polybutadiene, manufactured by Kuraray Co., Ltd.
Liquid polybutadiene A: liquid polybutadiene with a number average molecular weight of 3200, a weight average molecular weight/number average molecular weight of 1.29, a 1,2-vinyl bond amount of 90%, and a viscosity of 25.0 Pa·s at 45°C
Liquid polybutadiene B: liquid polybutadiene with a number average molecular weight of 4600, a weight average molecular weight/number average molecular weight of 3.79, a 1,2-vinyl bond amount of 1%, and a viscosity of 0.70 Pa·s at 40°C
DAD: Diallyl diphenate, manufactured by NISSHOKU TECHNO FINE CHEMICAL CO., LTD.
Antioxidant A: 2,6-di-t-butyl-p-cresol manufactured by SUMITOMO CHEMICAL Co., Ltd
Oil Yellow GG-S: N,N-diethyl-4-(phenylazo)aniline manufactured by ORIENT CHEMICAL INDUSTRIES CO., LTD.
C.I. Solvent Green 3: 1,4-bis[(4-methylphenyl)amino]-9,10-anthraquinone manufactured by Nippon Kayaku Co., Ltd.

**[Table 1]**

| | | Resin 1 | Resin 2 | Resin 3 | Resin 4 | Resin 5 | Resin 6 | Resin 7 | Resin 8 | Resin 9 | Resin 10 |
|---|---|---|---|---|---|---|---|---|---|---|---|
| Photosensitive resin composition (parts by mass) | D-KX405 | 67.5 | 67.5 | 67.5 | 67.5 | 67.5 | 67.5 | 67.5 | 67.5 | 67.5 | 67.5 |
| | LBR-352 | 21.5 | 21.5 | 21.5 | 21.5 | 21.5 | 21.5 | 21.5 | 21.5 | 21.5 | 21.5 |
| | LIR-305 | 0 | 0 | 0 | 0 | 0 | 0 | 0 | 0 | 0 | 0 |
| | Liquid polybutadiene A | 0 | 0 | 0 | 0 | 0 | 0 | 0 | 0 | 0 | 0 |
| | Liquid polybutadiene B | 0 | 0 | 0 | 0 | 0 | 0 | 0 | 0 | 0 | 0 |
| | 1,9-Nonanediol diacrylate | 9 | 9 | 9 | 9 | 9 | 9 | 9 | 9 | 9 | 9 |
| | 1,6-Hexanediol dimethacrylate | 2 | 2 | 2 | 2 | 2 | 2 | 2 | 2 | 2 | 2 |
| | DPNG | 2.2 | 0.1 | 5.5 | 0 | 0 | 0 | 0 | 0 | 0 | 0 |
| | DAD | 0 | 0 | 0 | 0 | 2.2 | 0 | 0 | 0 | 0 | 0 |
| | 2,2-Dimethoxy-2-phenylacetophenone | 4 | 4 | 4 | 4 | 4 | 4 | 4 | 4 | 4 | 4 |
| | Irganox 1520L | 0.4 | 0.4 | 0.4 | 0.4 | 0.4 | 0.4 | 0.4 | 0.4 | 0.05 | 0.11 |
| | Antioxidant A | 0 | 0 | 0 | 0 | 0 | 0.05 | 0.15 | 0.25 | 0 | 0 |
| | Solvent Green 28 | 0.01 | 0.01 | 0.01 | 0.01 | 0.01 | 0.01 | 0.01 | 0.01 | 0.01 | 0.01 |
| | Oil Yellow GG-S | 0 | 0 | 0 | 0 | 0 | 0 | 0 | 0 | 0 | 0 |
| | Solvent Green 3 | 0 | 0 | 0 | 0 | 0 | 0 | 0 | 0 | 0 | 0 |
| Photo-DSC measurement value | Time from irradiation to heat generation peak (seconds) | 8 | 8.3 | 8 | 8.3 | 8.3 | 8.3 | 8.3 | 8.5 | 7.1 | 7.1 |
| | Amount of heat generation at peak top (µW/mg) | 2200 | 2465 | 2765 | 2307 | 2387 | 2486 | 2795 | 2985 | 2963 | 2802 |

**[Table 2]**

| | | Resin 11 | Resin 12 | Resin 13 | Resin 14 | Resin 15 | Resin 16 | Resin 17 | Resin 18 | Resin 19 | Resin 20 |
|---|---|---|---|---|---|---|---|---|---|---|---|
| Photosensitive resin composition (parts by mass) | D-KX405 | 67.5 | 67.5 | 67.5 | 67.5 | 67.5 | 61 | 61 | 59.5 | 58 | 67.5 |
| | LBR-352 | 21.5 | 21.5 | 21.5 | 21.5 | 21.5 | 0 | 0 | 5 | 6.5 | 21.5 |
| | LIR-305 | 0 | 0 | 0 | 0 | 0 | 20 | 20 | 0 | 0 | 0 |
| | Liquid polybutadiene A | 0 | 0 | 0 | 0 | 0 | 0 | 0 | 11.3 | 10.3 | 0 |
| | Liquid polybutadiene B | 0 | 0 | 0 | 0 | 0 | 0 | 0 | 11.2 | 10.2 | 0 |
| | 1,9-Nonanediol diacrylate | 9 | 9 | 9 | 9 | 9 | 7 | 7 | 7 | 7 | 9 |
| | 1,6-Hexanediol dimethacrylate | 2 | 2 | 2 | 2 | 2 | 8 | 8 | 0 | 0 | 2 |
| | DPNG | 0 | 0 | 0 | 0 | 0 | 0 | 0 | 0 | 0 | 0 |
| | DAD | 0 | 0 | 0 | 0 | 0 | 0 | 0 | 0 | 0 | 0 |
| | 2,2-Dimethoxy-2-phenylacetophenone | 4 | 4 | 4 | 4 | 4 | 3 | 3 | 2 | 2 | 4 |
| | Irganox 1520L | 0.48 | 1.1 | 0.4 | 0.4 | 0.4 | 0 | 0 | 0.3 | 0.3 | 0.4 |
| | Antioxidant A | 0 | 0 | 0 | 0 | 0 | 1 | 1 | 0.05 | 0 | 0 |
| | Solvent Green 28 | 0.01 | 0.01 | 0.05 | 0.1 | 0.005 | 0.03 | 0.05 | 0.01 | 0.01 | 0 |
| | Oil Yellow GG-S | 0 | 0 | 0 | 0 | 0 | 0 | 0 | 0 | 0 | 0 |
| | Solvent Green 3 | 0 | 0 | 0 | 0 | 0 | 0 | 0 | 0 | 0 | 0 |
| Photo-DSC measurement value | Time from irradiation to heat generation peak (seconds) | 8.5 | 8.5 | 8.3 | 8.5 | 8.3 | 8.5 | 8.5 | 8.3 | 8.3 | 8.3 |
| | Amount of heat generation at peak top (µW/mg) | 1980 | 1879 | 2005 | 1846 | 2935 | 1823 | 2135 | 2796 | 2116 | 2756 |

**[Table 3]**

| | | Resin 21 | Resin 22 | Resin 23 | Resin 24 | Resin 25 | Resin 26 | Resin 27 | Resin 28 |
|---|---|---|---|---|---|---|---|---|---|
| Photosensitive resin composition (parts by mass) | D-KX405 | 67.5 | 67.5 | 67.5 | 67.5 | 67.5 | 61 | 59.5 | 58 |
| | LBR-352 | 21.5 | 21.5 | 21.5 | 21.5 | 21.5 | 0 | 5 | 6.5 |
| | LIR-305 | 0 | 0 | 0 | 0 | 20 | 20 | 0 | 0 |
| | Liquid polybutadiene A | 0 | 0 | 0 | 0 | 0 | 0 | 11.3 | 10.3 |
| | Liquid polybutadiene B | 0 | 0 | 0 | 0 | 0 | 0 | 11.2 | 10.2 |
| | 1,9-Nonanediol diacrylate | 9 | 9 | 9 | 9 | 7 | 7 | 7 | 7 |
| | 1,6-Hexanediol dimethacrylate | 2 | 2 | 2 | 2 | 8 | 8 | 0 | 0 |
| | DPNG | 0 | 0 | 0 | 0 | 0 | 0 | 0 | 0 |
| | DAD | 0 | 0 | 0 | 0 | 0 | 0 | 0 | 0 |
| | 2,2-Dimethoxy-2-phenylacetophenone | 8 | 8 | 4 | 4 | 3 | 3 | 2 | 2 |
| | Irganox 1520L | 0.4 | 0.4 | 3.5 | 0.4 | 0 | 0 | 3.5 | 6 |
| | Antioxidant A | 0 | 0.7 | 0 | 0 | 1 | 1 | 0.5 | 0 |
| | Solvent Green 28 | 0 | 0 | 0.01 | 0.6 | 0 | 0 | 0.01 | 0.01 |
| | Oil Yellow GG-S | 0 | 0 | 0 | 0 | 0.03 | 0 | 0 | 0 |
| | Solvent Green 3 | 0 | 0 | 0 | 0 | 0 | 0.05 | 0 | 0 |
| Photo-DSC measurement value | Time from irradiation to heat generation peak (seconds) | 6.6 | 12.2 | 16.2 | 10.3 | 9 | 8.5 | 16.2 | 16.2 |
| | Amount of heat generation at peak top (µW/mg) | 3529 | 3210 | 1560 | 1673 | 3180 | 3622 | 1886 | 1536 |

### [Example 1]

### <Preparation of Sample for Photo-DSC Measurement>

The photosensitive resin composition 1 was sandwiched with release films (manufactured by Mitsubishi Chemical Corporation, DIAFOIL MRV100), and subjected to a pressure of 200 kg/cm² at the condition of 120°C for 4 minutes using a 0.5 mm spacer with a heating press, and then cooled to obtain a sample for photo-DSC measurement of 10 cm in length × 10 cm in width × 0.5 mm in thickness.

### <Preparation of Flexographic Printing Plate under Low-Illuminance Exposure Conditions>

The photosensitive resin composition was added to an extruder. Then, the formed surface of the adhesive layer of the support obtained in the <Production Examples> described above was laminated to one side of the photosensitive resin composition layer extruded from a T-die, and a release film (manufactured by Mitsubishi Chemical Corporation, DIAFOIL MRV100) was laminated to the side opposite to the support-laminated side of the photosensitive resin composition layer, thereby obtaining a laminate of the support and the photosensitive resin composition layer.

The release film was then peeled, and the laminate for forming an infrared ray ablation layer obtained in the [Production Examples] described above was laminated so that the infrared ray ablation layer was in contact with the photosensitive resin composition layer to obtain an original flexographic printing plate of a plate thickness of 1.8 mm.

Then, the original flexographic printing plate was exposed from the support (polyethylene terephthalate film) side using an exposure machine "AFP-1216" so that the pattern height (RD) after curing was about 0.7 mm.

Next, the cover film of the infrared ray ablation layer was peeled off, and drawing was performed onto the infrared ray ablation layer using a laser drawing machine "CDI Crystal 5080" manufactured by ESKO, and then an image (relief) exposure was performed by irradiating 6000 mJ/cm² with ultraviolet ray at an illuminance of 10 to 12 mW/cm² using the exposure machine described above from the infrared ray ablation layer side.

Then, development was performed using Solvit (manufactured by MacDermid Performance Solutions, trademark, a mixed organic solvent of 60% by mass of hydrocarbons and 40% by mass of aliphatic alcohol, boiling point 155-205°C) as a developing solution with a developing machine "AFP-1321P" (manufactured by Asahi Kasei Corporation, trademark) at a liquid temperature of 30°C with a speed of 135 mm/min, and then drying was performed at 60°C for 2 hours.

Subsequently, as post-processing exposure, an exposure of 2,000 mJ/cm² was performed on the entire plate surface using a sterilization lamp with a center wavelength of 254 nm, followed by an exposure of 1,000 mJ/cm² using an ultraviolet ray fluorescent lamp to obtain a flexographic printing plate having a plate thickness of 1.7 mm.

### <Preparation of Flexographic Printing Plate under High-Illuminance Exposure Conditions>

Using the exposure machine "XPS Crystal 5080" manufactured by ESKO, and after drawing on the infrared ray ablation layer, exposure was performed simultaneously from the support (polyethylene terephthalate film) side and from the infrared ray ablation layer side of the original flexographic printing plate.

The exposure was performed under exposure conditions of using "BFTH 1.70 (067)" built into the exposure machine at an illuminance of 311 mW/cm².

Other conditions were the same as the preparation of a flexographic printing plate under low-illuminance exposure conditions, and a flexographic printing plate was prepared.

### [Examples 2 to 20, Comparative Examples 1 to 8]

The photosensitive resin composition used was changed as shown in Tables 4 to 6 below. Other conditions were the same as Example 1, and a sample for photo-DSC measurement and a flexographic printing plate were obtained.

### [Example 21]

A sample for photo-DSC measurement was obtained in the same manner as in Example 1 except changing the photosensitive resin composition used. Subsequently, the processes up to exposure were performed on the original flexographic printing plate in the same manner as in Example 1, and the original flexographic printing plate after exposure was fixed to a motor-driven metal roll with a diameter of 35 cm using a double-sided adhesive tape.

A commercially available polyester nonwoven fabric was placed to be passable between a plurality of heatable metal rolls with a diameter of 5 cm.

An infrared lamp for heating the photosensitive resin composition layer relatively quickly was fixed on the metal roll holding the original flexographic printing plate.

The infrared lamp was illuminated and the metal roll heated to 170°C was rotated slowly (about 2 rpm) by the motor. On the metal roll, the non-woven fabric was contacted with the photosensitive resin composition surface of the original flexographic printing plate at a contact pressure of about 2.5 × 10⁵ Pa and passed through.

The roll holding the original flexographic printing plate was subjected to 14 cycles, and the uncured portion of the photosensitive resin composition layer was removed by heat development to obtain a flexographic printing plate.

The photosensitive resin compositions used in each of Examples 2 to 21 and Comparative Examples 1 to 8 are shown in Tables 4 to 6.

### [Evaluation Method]

### <Formability of Highlight Dots under Low-Illuminance Exposure Conditions>

On the obtained flexographic printing plate, 1% to 10% of dots on AM150 line were observed with a 100× microscope and the minimum formed dot was evaluated.

The dot area ratio is the proportion (%) of the dot area per unit area, and the minimum formed dot is the smallest dot area ratio of a dot design drawn on an infrared ray ablation layer in which there is no defective formation at the top, and dots with a flat top shape can be formed during plate-making with the design.

The evaluation was performed according to the following criteria.

The evaluation results are shown in Tables 4 to 6 below.

### [Evaluation Criteria]

A: 1% or more and less than 2%
B: 2% or more and less than 2.5%
C: 2.5% or more and less than 3%
D: 3% or more and less than 4%
E: 4% or more

### <Formability of Halftone Dots under High-Illuminance Exposure Conditions>

The top area ratio (AM150 line, 50% dot location) of the halftone dot image portions on the flexographic printing plate obtained from the above-described <Preparation of Flexographic Printing Plate under High-Illuminance Exposure Conditions> was measured with FLEX3PRO (manufactured by Avid Flex CO., LTD.).

The dot area ratio was evaluated according to the following criteria, considering that the actual printing produces about 10-20% expansion, and the smaller the better.

The evaluation results are shown in Tables 4 to 6 below.

### [Evaluation Criteria]

A: Less than 49%
B: 49% or more and less than 51%
C: 51% or more and less than 52%
D: 52% or more and less than 53%
E: 53% or more

### <Formability of Independent Points under Low-Illuminance Exposure Conditions>

The independent points on the obtained flexographic printing plate were observed with a loupe and the formability of the independent points was evaluated.

The smallest independent point that can be reproduced without collapse in the development process was taken as the minimum independent point, and the diameter of the independent point design drawn on an infrared ray ablation layer to form the minimum independent point was evaluated according to the following criteria.

The evaluation results are shown in Tables 4 to 6 below.

### [Evaluation Criteria]

A: Minimum independent point of 100 µm or less
B: Minimum independent point of more than 100 µm and 150 µm or less
C: Minimum independent point of more than 150 µm

It was evaluated that the smaller the minimum independent point, the more accurately the fine image can be transferred and the denser the printing can be.

**[Table 4]**

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| | Photosensitive resin composition | Resin 1 | Resin 2 | Resin 3 | Resin 4 | Resin 5 | Resin 6 | Resin 7 | Resin 8 | Resin 9 | Resin 10 |
| Results | Formability of highlight dots under low-illuminance exposure conditions | A | B | A | B | B | B | C | C | A | A |
| | Formability of halftone dots under high-illuminance exposure conditions | A | A | B | A | A | B | C | D | D | C |
| | Minimum independent point | A | A | A | A | A | B | B | B | A | A |

**[Table 5]**

| | | Example 11 | Example 12 | Example 13 | Example 14 | Example 15 | Example 16 | Example 17 | Example 18 | Example 19 | Example 20 | Example 21 |
|---|---|---|---|---|---|---|---|---|---|---|---|---|
| | Photosensitive resin composition | Resin 11 | Resin 12 | Resin 13 | Resin 14 | Resin 15 | Resin 16 | Resin 17 | Resin 18 | Resin 19 | Resin 20 | Resin 4 |
| Results | Formability of highlight dots under low-illuminance exposure conditions | C | D | C | D | B | D | D | C | C | B | B |
| | Formability of halftone dots under high-illuminance exposure conditions | A | A | A | A | D | A | A | B | A | C | A |
| | Minimum independent point | A | B | A | A | A | B | B | B | B | A | A |

**[Table 6]**

| | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|
| | Photosensitive resin composition | Resin 21 | Resin 22 | Resin 23 | Resin 24 | Resin 25 | Resin 26 | Resin 27 | Resin 28 |
| Results | Formability of highlight dots under low-illuminance exposure conditions | A | E | E | E | E | D | E | E |
| | Formability of halftone dots under high-illuminance exposure conditions | E | E | D | D | E | E | A | A |
| | Minimum independent point | C | C | C | C | C | C | C | C |

This application is based on the Japanese Patent Application (Patent Application No. 2023-071540) filed with the Japan Patent Office on April 25, 2023, the contents of which are hereby incorporated by reference.

### Industrial Applicability

The original flexographic printing plate according to the present invention has industrial applicability in the flexographic printing plate production field.

### Reference Signs List

(a) Support
(b) Photosensitive resin composition layer
(b') Print pattern
(c) Infrared ray ablation layer
(c') Mask of infrared ray ablation layer

## Claims

1. An original flexographic printing plate comprising: at least a support (a); a photosensitive resin composition layer (b) laminated thereon; and an infrared ray ablation layer (c) laminated thereon, wherein
when a photo-differential scanning calorimetry is carried out under normal temperature and normal pressure while irradiating a molded product of 0.5 mm thickness formed of a photosensitive resin composition constituting the photosensitive resin composition layer (b) with a light of 365 nm wavelength at an illuminance of 10 mW/cm², a time from start of irradiation to a heat generation peak is 4.0 seconds or more and 8.5 seconds or less, and an amount of heat generation at a peak top is 1500 µW/mg or more and 3000 µW/mg or less.

2. The original flexographic printing plate according to claim 1, wherein
the photosensitive resin composition layer (b) comprises at least one or more selected from the group consisting of an ethylenically unsaturated compound (b-2), a photopolymerization initiator (b-3), a stabilizer (b-5), and a dye (b-6).

3. The original flexographic printing plate according to claim 2, wherein
the dye (b-6) comprises a dye (B-6) having a 1,4-diamino-5,8-dihydroxyanthraquinone backbone in a molecular structure.

4. The original flexographic printing plate according to claim 3, wherein
the dye (B-6) has a molecular structure represented by the following formula (1): 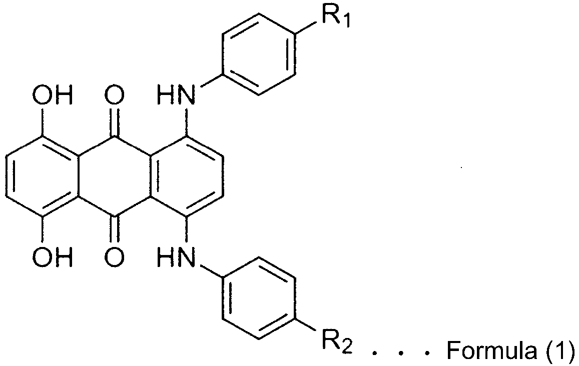
wherein R₁ and R₂ each independently represent an alkyl group having 1 to 4 carbon atoms.

5. The original flexographic printing plate according to claim 4, wherein
a dye having a molecular structure represented by the formula (1) is comprised in the photosensitive resin composition layer (b) in an amount of 0.005% by mass or more and 0.1% by mass or less.

6. The original flexographic printing plate according to any one of claims 2 to 5, wherein
at least one stabilizer (B-5), which is a compound represented by the following formula (2) or (3), is comprised as the stabilizer (b-5); and
a content of the stabilizer (B-5) is 0.45% by mass or less of the photosensitive resin composition layer (b): 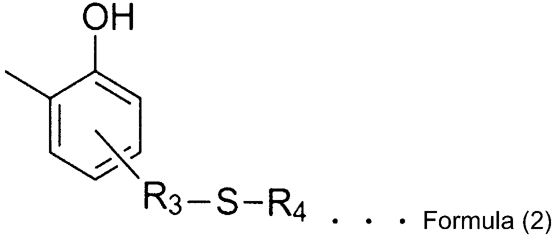 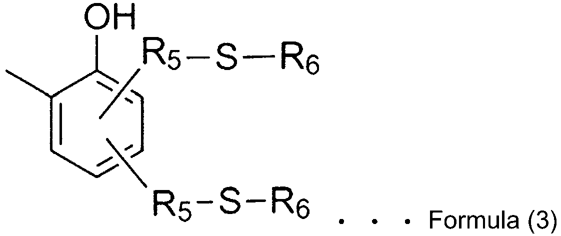
wherein, R₃ and R₅ each independently represent an alkyl group having 1 to 4 carbon atoms; and R₄ and R₆ each independently represent an alkyl group having 1 to 12 carbon atoms.

7. The original flexographic printing plate according to claim 6, wherein
the content of the stabilizer (B-5) is 60% by mass or more and 100% by mass or less based on the total amount of the stabilizer (b-5).

8. The original flexographic printing plate according to any one of claims 2 to 5, wherein
an ethylenically unsaturated compound (B-2) having a structure represented by the following formula (4) is comprised as the ethylenically unsaturated compound (b-2): 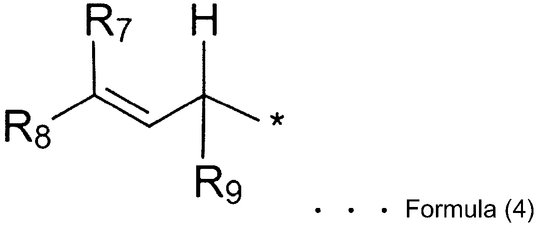
wherein, R₇, R₈, and R₉ each independently represent a hydrogen atom or a hydrocarbon group having 1 to 3 carbon atoms; and * represents a bond.

9. The original flexographic printing plate according to claim 8, wherein
a compound represented by the following formula (5) is comprised as the ethylenically unsaturated compound (B-2):

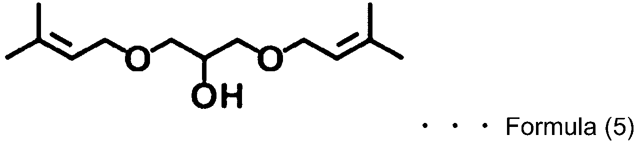

10. A method for producing a flexographic printing plate using the original flexographic printing plate according to any one of claims 1 to 5 comprising:
a first step of performing ultraviolet ray irradiation from a side of the support (a);
a second step of laser-ablating an infrared ray ablation layer (c) provided on the photosensitive resin composition layer (b) to form a negative pattern;
a third step of irradiating the photosensitive resin composition layer (b) with an ultraviolet ray for pattern exposure using, as a mask, the infrared ray ablation layer (c) on which the pattern is drawn and processed; and
a fourth step of removing an unexposed portion of the photosensitive resin composition layer (b).

11. The method for producing a flexographic printing plate according to claim 10, wherein
solvent development is performed in the fourth step of removing the unexposed portion of the photosensitive resin composition layer (b).

12. The method for producing a flexographic printing plate according to claim 10, wherein
heat development is performed in the fourth step of removing the unexposed portion of the photosensitive resin composition layer (b).
